# EUROPÄISCHE PATENTSCHRIFT

(11) **EP 2 457 254 B1**
(45) Veröffentlichungstag und Bekanntmachung des Hinweises auf die Patenterteilung: **18.03.2020**
(21) Anmeldenummer: 10734486.3
(22) Anmeldetag: 16.07.2010
(51) Int. Cl.: H01L 25/16, F21K 99/00, H01L 25/075, H01L 33/00, H01L 33/50

(54) **VERFAHREN ZUR HERSTELLUNG EINES LEUCHTMITTELS UND LEUCHTMITTEL**
METHOD FOR MANUFACTURING A LIGHT SOURCE AND LIGHT SOURCE
PROCÉDÉ DE FABRICATION D'UN LUMINAIRE, AINSI QUE LUMINAIRE

(30) Priorität: 20.07.2009 DE 102009033915
(43) Veröffentlichungstag der Anmeldung: 30.05.2012
(73) Patentinhaber: OSRAM Opto Semiconductors GmbH, 93055 Regensburg (DE)
(72) Erfinder: HAHN, Berthold, 93155 Hemau (DE); MAUTE, Markus, 93087 Altelofsheim (DE); HERRMANN, Siegfried, 94362 Neukirchen (DE)
(74) Vertreter: Epping - Hermann - Fischer
(86) Internationale Anmeldenummer: PCT/EP2010/060345
(87) Internationale Veröffentlichungsnummer: WO 2011/009821

(56) Entgegenhaltungen:
- EP-A1- 0 977 063
- EP-A2- 1 115 155
- WO-A1-2008/062783
- US-A1- 2005 212 406
- TAKAHASHI K ET AL: "High density LED display panel on silicon microreflector and integrated circuit", ELECTRONIC MANUFACTURING TECHNOLOGY SYMPOSIUM, 1995, PROCEEDINGS OF 19 95 JAPAN INTERNATIONAL, 18TH IEEE/CPMT INTERNATIONAL OMIYA, JAPAN 4-6 DEC. 1995, NEW YORK, NY, USA,IEEE, US, 4. Dezember 1995 (1995-12-04), Seiten 272-275, XP010195599, ISBN: 978-0-7803-3622-3

## Beschreibung

Es wird ein Verfahren zur Herstellung eines Leuchtmittels angegeben. Ferner wird ein Leuchtmittel angegeben, das vorzugsweise mittels des Verfahrens herstellbar ist.

Die Druckschrift WO 2008/062783 beschreibt ein Verfahren zur Herstellung von Leuchtdioden, bei dem Leuchtdiodenchips an einem gemeinsamen strahlungsdurchlässigen Träger befestigt werden. Die Befestigung erfolgt dabei mittels eines Klebstoffes, dem jeweils ein Konversionsmaterial beigemischt ist, welches die in den Leuchtdiodenchips erzeugte elektromagnetische Strahlung in rotes, grünes oder blaues Licht konvertiert.

Die Druckschrift EP 1115155 beschreibt ein optisches Informationsverarbeitungsgerät, bei dem die Kontaktierung jedes Halbleiterkörpers mittels eines eineindeutig zugeordneten Paares von Anschlussstellen erfolgt.

Das hier beschriebene Leuchtmittel kann beispielsweise in einem miniaturisierten Vollfarbendisplay Verwendung finden. Darüber hinaus ist es möglich, dass das hier beschriebene Leuchtmittel als Lichtquelle in einer optischen Projektionsvorrichtung, zum Beispiel in einem miniaturisierten Beamer Verwendung findet.

Die Erfindung betrifft ein Verfahren gemäß Anspruch 1 sowie ein Leuchtmittel gemäß Anspruch 5.

Gemäß dem Verfahren zur Herstellung eines Leuchtmittels wird zunächst eine Vielzahl von Leuchtdioden bereitgestellt. Jede der Leuchtdioden umfasst einen strahlungsdurchlässigen Träger und zumindest zwei räumlich voneinander getrennte Halbleiterkörper. Die Halbleiterkörper sind beispielsweise an einer Oberseite des strahlungsdurchlässigen Trägers auf dem strahlungsdurchlässigen Träger angeordnet. Die Oberseite des Trägers bildet auch die Oberseite der Leuchtdiode.

Jeder der Halbleiterkörper ist zur Erzeugung von elektromagnetischer Strahlung vorgesehen und die Halbleiterkörper sind dazu getrennt voneinander ansteuerbar. Das heißt, die Halbleiterkörper der Leuchtdiode können zu unterschiedlichen Zeiten oder gleichzeitig elektromagnetische Strahlung emittieren.

Der strahlungsdurchlässige Träger ist für die von den Halbleiterkörpern im Betrieb der Leuchtdiode emittierte elektromagnetische Strahlung durchlässig, vorzugsweise klarsichtig, also transparent. Der strahlungsdurchlässige Träger ist beispielsweise durch eine strahlungsdurchlässige Folie (engl. foil) gebildet.

Die Halbleiterkörper der Leuchtdioden sind vorzugsweise frei von einem Wachstumssubstrat. Das heißt, die Halbleiterkörper der Leuchtdioden sind jeweils epitaktisch gewachsen, das Aufwachssubstrat, auf dem die Halbleiterkörper epitaktisch abgeschieden wurden, ist von den Halbleiterkörpern abgetrennt.

Gemäß dem Verfahren wird in einem weiteren Verfahrensschritt ein Chipverbund aus Halbleiterchips bereitgestellt, die zur Ansteuerung der Leuchtdioden vorgesehen sind. Jeder der Halbleiterchips umfasst dabei an seiner Oberseite zumindest zwei Anschlussstellen, die zum Anschließen einer Leuchtdiode vorgesehen sind. Bei den Halbleiterchips des Chipverbundes handelt es sich zum Beispiel um so genannte CMOS-Chips (complementary metal oxide semiconductor-Chips). CMOS-Chips sind Halbleiterbauelemente, bei denen sowohl p-Kanal als auch n-Kanal MOSFETs auf einem gemeinsamen Substrat verwendet werden.

Gemäß zumindest dem Verfahren wird zumindest eine der Leuchtdioden mit einem der CMOS-Chips verbunden, wobei die Leuchtdiode an ihrer Oberseite an der Oberseite des CMOS-Chips angeordnet wird und jeder Halbleiterkörper der Leuchtdiode mit einer Anschlussstelle des CMOS-Chips verbunden wird. Das heißt, die Leuchtdiode und der CMOS-Chip sind mit ihren Oberseiten einander zugewandt und die Halbleiterkörper der Leuchtdiode werden mit entsprechenden Anschlussstellen des CMOS-Chips verbunden. Der CMOS-Chip weist dabei bevorzugt eine Anzahl von Anschlussstellen auf, die wenigstens der Anzahl der Halbleiterkörper der Leuchtdiode entspricht. Zum Beispiel wird auf jeden CMOS-Chip des Chipverbundes genau eine Leuchtdiode aufgesetzt, deren Halbleiterkörper jeweils mit zugeordneten Anschlussstellen des zugeordneten CMOS-Chips verbunden sind. Über die Anschlussstellen des CMOS-Chips können die Leuchtdioden jeweils angesteuert werden, so dass eine Erzeugung von elektromagnetischer Strahlung durch die Halbleiterkörper durch den der Leuchtdiode zugeordneten Chip gesteuert wird.

Gemäß dem Verfahren wird zunächst eine Vielzahl von Leuchtdioden bereitgestellt, wobei jede Leuchtdiode einen strahlungsdurchlässigen Träger und zumindest zwei räumlich voneinander getrennte Halbleiterkörper aufweist, jeder Halbleiterkörper zur Erzeugung von elektromagnetischer Strahlung vorgesehen ist, die Halbleiterkörper getrennt voneinander ansteuerbar sind und die Halbleiterkörper an der Oberseite des strahlungsdurchlässigen Trägers auf dem strahlungsdurchlässigen Träger angeordnet sind. In einem weiteren Verfahrensschritt wird ein Chipverbund bestehend aus zumindest einem CMOS-Chip bereitgestellt, wobei jeder CMOS-Chip an seiner Oberseite zumindest zwei Anschlussstellen aufweist. Anschließend wird zumindest eine der Leuchtdioden mit einem der CMOS-Chips verbunden, wobei die Leuchtdiode an ihrer Oberseite an der Oberseite des CMOS-Chips angeordnet wird und jeder Halbleiterkörper der Leuchtdiode mit einer Anschlussstelle des CMOS-Chips verbunden wird.

Es wird ferner ein Leuchtmittel angegeben. Gemäß dem Leuchtmittel umfasst das Leuchtmittel einen Chip zur Ansteuerung einer Leuchtdiode, beispielsweise einen CMOS-Chip, wobei der Chip an seiner Oberseite zumindest zwei Anschlussstellen aufweist.

Gemäß dem Leuchtmittel umfasst das Leuchtmittel zumindest eine Leuchtdiode, wobei jede Leuchtdiode des Leuchtmittels einen strahlungsdurchlässigen Träger und zumindest zwei räumlich voneinander getrennte Halbleiterkörper aufweist, jeder Halbleiterkörper zur Erzeugung von elektromagnetischer Strahlung vorgesehen ist, die Halbleiterkörper getrennt voneinander ansteuerbar sind und die Halbleiterkörper an der Oberseite des strahlungsdurchlässigen Trägers auf dem strahlungsdurchlässigen Träger angeordnet sind.

Dass die Halbleitekörper räumlich voneinander getrennt sind, kann zum Beispiel heißen, dass die Halbleiterkörper nicht durch ein gemeinsames Element, wie beispielsweise ein gemeinsames Aufwachssubstrat, miteinander verbunden sind. Die einzige mechanische Verbindung zwischen den Halbleiterkörpern ist dann zum Beispiel durch den strahlungsdurchlässigen Träger gegeben, auf dem die Halbleiterkörper angeordnet sind.

Gemäß dem Leuchtmittel sind sich die zumindest eine Leuchtdiode und der CMOS-Chip mit ihren Oberseiten einander zugewandt und jeder Halbleiterkörper der zumindest einen Leuchtdiode ist mit einer Anschlussstelle des CMOS-Chips verbunden. Dabei ist vorzugsweise jeder Halbleiterkörper der zumindest einen Leuchtdiode mit genau einer Anschlussstelle des CMOS-Chips verbunden, andere Halbleiterkörper der Leuchtdiode sind dann mit dieser Anschlussstelle des CMOS-Chips nicht verbunden. Das heißt, Halbleiterkörper und Anschlussstellen sind eineindeutig einander zugeordnet.

Gemäß dem Leuchtmittel umfasst das Leuchtmittel einen Ansteuerchip, zum Beispiel einen CMOS-Chip, wobei der CMOS-Chip an seiner Oberseite zumindest zwei Anschlussstellen aufweist. Das Leuchtmittel umfasst weiter zumindest eine Leuchtdiode, wobei die Leuchtdiode einen strahlungsdurchlässigen Träger und zumindest zwei räumlich voneinander getrennte Halbleiterkörper aufweist, jeder Halbleiterkörper zur Erzeugung von elektromagnetischer Strahlung vorgesehen ist, die Halbleiterkörper getrennt voneinander ansteuerbar sind und die Halbleiterkörper an der Oberseite des strahlungsdurchlässigen Trägers auf dem strahlungsdurchlässigen Träger angeordnet sind. Dabei sind die zumindest eine Leuchtdiode und der CMOS-Chip sich mit ihren Oberseiten zugewandt und jeder Halbleiterkörper der zumindest einen Leuchtdiode ist mit einer Anschlussstelle des CMOS-Chips verbunden.

Bevorzugt ist das hier beschriebene Leuchtmittel mit einem hier beschriebenen Verfahren herstellbar. Das bedeutet, sämtliche für das Verfahren beschriebenen Merkmale sind auch für das Leuchtmittel offenbart und umgekehrt.

Die folgenden Ausführungsformen beziehen sich sowohl auf das Verfahren zur Herstellung eines Leuchtmittels als auch auf das Leuchtmittel.

Gemäß zumindest einer Ausführungsform wird die Anschlussstelle mit einer dem strahlungsdurchlässigen Träger abgewandten Oberfläche des Halbleiterkörpers in direktem Kontakt gebracht. Das heißt, die Leuchtdiode wird derart auf den zugeordneten Chip aufgesetzt, dass sich ein Halbleiterkörper und die dem Halbleiterkörper zugeordnete Anschlussstelle des Chips berühren. Die Anschlussstelle wird dabei beispielsweise mit der p-leitenden Seite des Halbleiterkörpers elektrisch leitend verbunden, so dass die Anschlussstelle zur Kontaktierung der p-Seite des Halbleiterkörpers dient.

Gemäß zumindest einer Ausführungsform wird an der den Halbleiterkörpern abgewandten Unterseite des strahlungsdurchlässigen Trägers für zumindest einen der Halbleiterkörper ein Konversionselement auf den strahlungsdurchlässigen Träger derart aufgebracht, dass im Betrieb des Halbleiterkörpers von diesem emittierte elektromagnetische Strahlung durch das Konversionselement tritt und von diesem zumindest zum Teil wellenlängenkonvertiert wird.

Der Halbleiterkörper ist dabei vorzugsweise im Betrieb zur Erzeugung von elektromagnetischer Strahlung aus dem Spektralbereich von ultravioletter Strahlung und/oder blauem Licht vorgesehen. Beispielsweise können in diesem Fall sämtliche Halbleiterkörper der Leuchtdiode gleichartig ausgebildet sein, so dass sämtliche Halbleiterkörper der Leuchtdiode elektromagnetische Strahlung aus demselben Spektralbereich emittieren. Die den Halbleiterkörpern nachgeordneten Konversionselemente können sich dann unterscheiden. Auf diese Weise kann beispielsweise ein Leuchtmittel hergestellt werden, das im Betrieb grünes, rotes und blaues Licht erzeugen kann. Das grüne und das rote Licht werden dabei beispielsweise durch vollständige Wellenlängenkonversion der von den Halbleiterkörpern erzeugten elektromagnetischen Strahlung erzeugt.

Alternativ ist es auch möglich, dass die Halbleiterkörper jeder Leuchtdiode an sich schon zur Erzeugung von rotem, grünem und blauem Licht vorgesehen sind. Die Halbleiterkörper der Leuchtdiode unterscheiden sich dann voneinander.

Gemäß zumindest einer Ausführungsform liegen die Konversionselemente in einem Verbund vor. Das heißt, eine Vielzahl von Konversionselementen ist beispielsweise durch einen gemeinsamen Träger miteinander verbunden. Bei dem gemeinsamen Träger kann es sich zum Beispiel um ein Aufwachssubstrat handeln, auf das die Konversionselemente aufgebracht, zum Beispiel epitaktisch abgeschieden sind. Die Konversionselemente können dann zum Beispiel aus II/VI-Halbleitermaterialien gebildet sein. Die Vielzahl von Konversionselementen, die in einem Verbund vorliegen, wird dann vorzugsweise gleichzeitig mit der Vielzahl von Leuchtdioden verbunden. Dies kann beispielsweise nach dem Aufbringen der Leuchtdioden auf den Chip-Verbund erfolgen. Das Verbindungselement der Vielzahl von Konversionselementen, also beispielsweise das Aufwachssubstrat, kann nach dem Verbinden mit den Leuchtdioden entfernt werden.

Alternativ ist es aber auch möglich, dass die Konversionselemente einzeln auf die Leuchtdioden aufgebracht werden. Die Konversionselemente können dann beispielsweise auch mit keramischen Leuchtstoffen wie beispielsweise Cerdotiertem YAG gebildet sein.

Gemäß zumindest einer Ausführungsform wird der Verbund aus Chip-Verbund und einer Vielzahl von Leuchtdioden zu einzelnen Leuchtmitteln vereinzelt, von denen jedes Leuchtmittel zumindest eine Leuchtdiode umfasst, wobei beim Vereinzeln lediglich der Chip-Verbund durchtrennt wird.

Vorliegend werden die Leuchtdioden einzeln mit zugeordneten Anschlussstellen der Chips des Chipverbundes verbunden. Das heißt, beim Verbinden mit dem Chipverbund liegen die Leuchtdioden selbst nicht in einem Verbund vor, sondern es handelt sich bei den Leuchtdioden um diskrete Bauelemente, die einzeln auf dem Chipverbund aufgebracht werden können. Zum Vereinzeln des Chip-Verbundes ist es daher nicht notwendig, durch die Leuchtdioden zu vereinzeln, lediglich der Chip-Verbund selbst muss durchtrennt werden. Auf diese Weise kann es nicht zu Beschädigungen der Leuchtdioden durch ein Durchtrennen der Leuchtdioden kommen, da dies entfällt. Ferner minimiert die separate Montage der Leuchtdioden auf dem Chip-Verbund die Wechselwirkung der einzelnen Prozessierungsschritte. Ferner ist es bei der separaten Montage der Leuchtdioden möglich, diese mit einer sehr hohen Genauigkeit von unter 1 µm auf dem zugeordneten Chip des Chip-Verbundes zu platzieren. Durch das Verbinden der Leuchtdioden mit Ansteuer-Chips entfällt eine Ansteuerschaltung und/oder eine aufwendige Verdrahtung für die -Leuchtdioden selbst, was die Verwendung besonders kostengünstiger Leuchtdioden mit kleiner Querschnittsfläche erlaubt. Ferner können die einzelnen Leuchtdioden vor dem Verbinden mit den Ansteuerchips getestet werden, was zu einer Verringerung an Ausschuss von Leuchtmitteln führt.

Gemäß dem Verfahren und dem Leuchtmittel weist die zumindest eine Leuchtdiode an ihrer den Halbleiterkörpern abgewandten Seite des strahlungsdurchlässigen Trägers eine Anschlussstelle auf, die zur gemeinsamen elektrischen Kontaktierung aller Halbleiterkörper der Leuchtdiode vorgesehen ist. Bei der gemeinsamen Anschlussstelle handelt es sich beispielsweise um eine Anschlussstelle, über die die Halbleiterkörper der Leuchtdiode n-seitig kontaktiert werden können. Die n-Seiten der Halbleiterkörper liegen dann auf einem gemeinsamen Potential. Ein getrenntes Ansteuern der Halbleiterkörper erfolgt durch eine Bestromung über die zugeordnete Anschlussstelle des zugeordneten CMOS-Chips. Über diese Anschlussstelle werden die Halbleiterkörper dann p-seitig kontaktiert. Dabei kann die Polarität auch vertauscht werden, das heißt, die Anschlussstelle auf dem strahlungsdurchlässigen Träger kann dann zur p-seitigen Kontaktierung der Halbleiterkörper vorgesehen sein.

Gemäß zumindest einer Ausführungsform umfasst der strahlungsdurchlässige Träger der zumindest einen Leuchtdiode eine Kunststofffolie in die und/oder auf die elektrische Leitungen zur Kontaktierung der Halbleiterkörper angeordnet sind. Das heißt, der strahlungsdurchlässige Träger selbst ist aus einem elektrisch isolierenden Material gebildet. Beispielsweise sind in das elektrisch isolierende Material des strahlungsdurchlässigen Trägers Durchkontaktierungen eingebracht, welche die Halbleiterkörper an der Oberseite des Trägers mit der Anschlussstelle an der Unterseite des Trägers verbinden. Die elektrischen Leitungen zur Verbindung der Halbleiterkörper mit der Anschlussstelle können jedoch auch auf den Außenflächen der Kunststofffolie verlaufen.

Im Folgenden werden das hier beschriebene Verfahren sowie das hier beschriebene Leuchtmittel anhand von Ausführungsbeispielen und den zugehörigen Figuren näher erläutert.

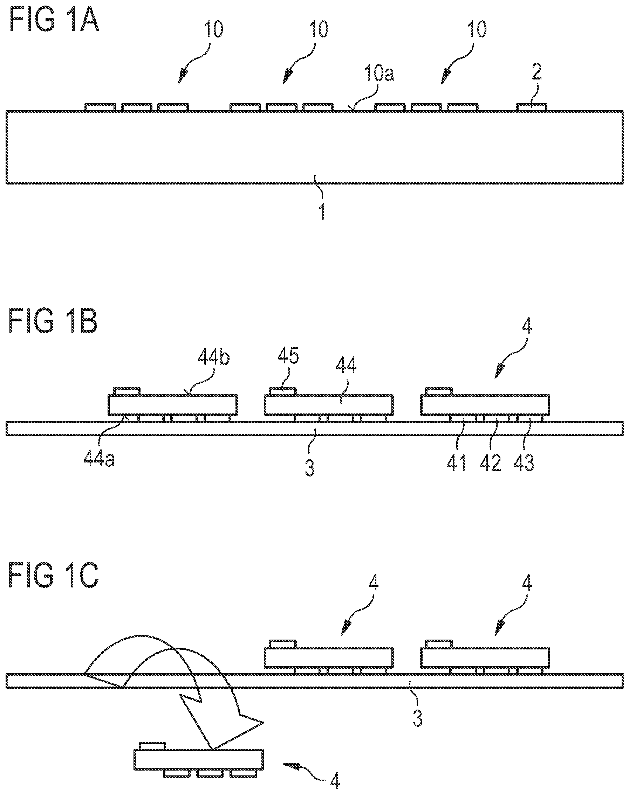

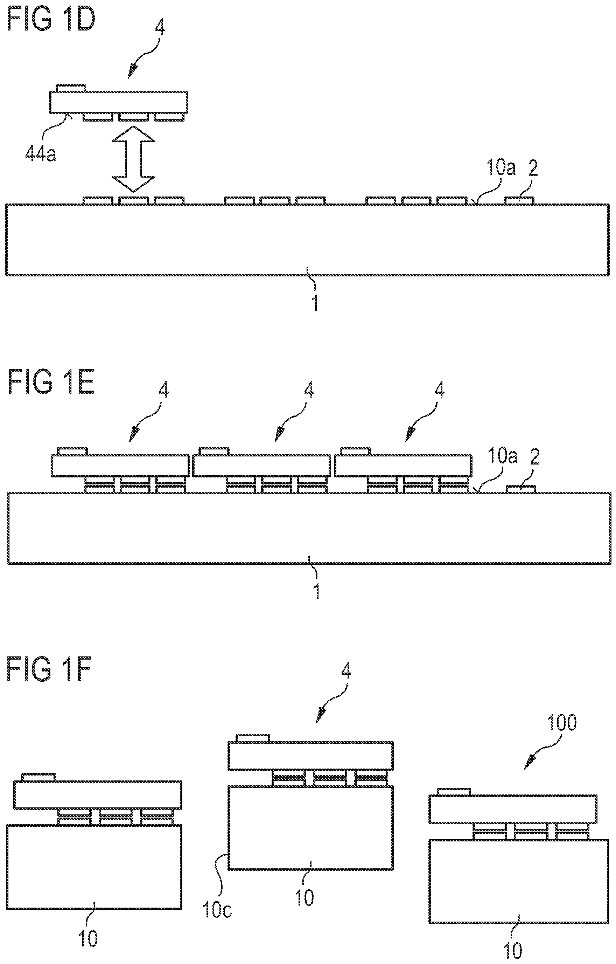

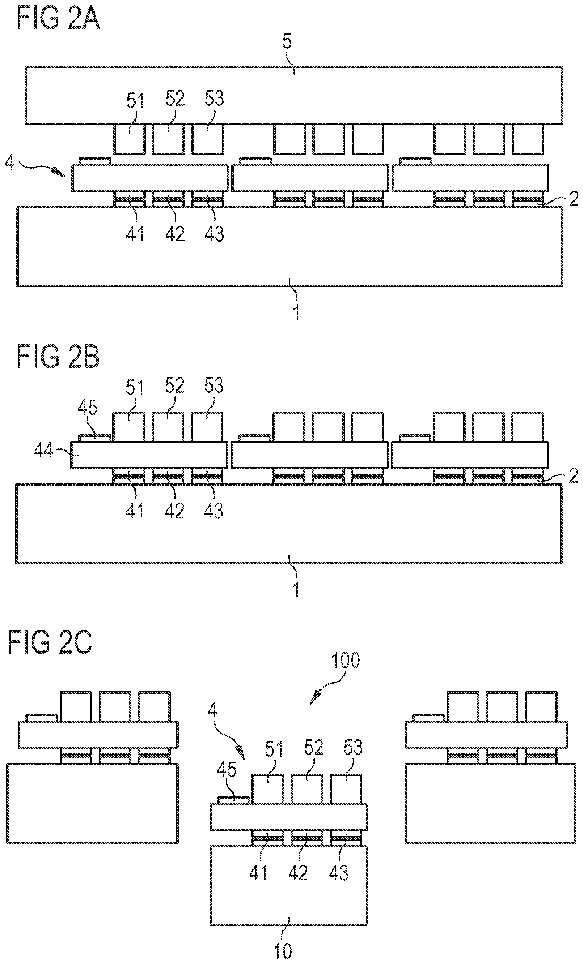

In Verbindung mit den Figuren 1 und 2 sind anhand schematischer Schnittdarstellungen Ausführungsbeispiele des hier beschriebenen Verfahrens und des hier beschriebenen Leuchtmittels näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1A zeigt in einer schematischen Schnittdarstellung einen Chip-Verbund 1 mit einer Vielzahl von CMOS-Chips 10. An der Oberseite 10a jedes CMOS-Chips 10 sind drei Anschlussstellen 2 angeordnet. Jede der Anschlussstellen 2 ist zur Bestromung des Halbleiterkörpers einer Leuchtdiode vorgesehen.

In der schematischen Schnittdarstellung der Figur 1B sind drei Leuchtdioden 4 dargestellt, die auf einem gemeinsamen Träger 3, zum Beispiel einer Folie, angeordnet sind. Die Leuchtdioden 4 sind, wie in der Figur 1C gezeigt, einzeln vom Träger 3 separierbar.

Jede Leuchtdiode 4 umfasst einen strahlungsdurchlässigen Träger 44 an dessen Oberseite 44a jeweils drei Halbleiterkörper 41, 42, 43 angeordnet sind. Die Halbleiterkörper 41, 42, 43 sind räumlich voneinander getrennt und lediglich über den strahlungsdurchlässigen Träger 44 miteinander verbunden.

Bei dem strahlungsdurchlässigen Träger 44 handelt es sich um eine transparente Kunststofffolie.

Jede Leuchtdiode 4 umfasst ferner an der der Oberseite 44a abgewandten Unterseite 44b des Trägers 44 eine Anschlussstelle 45, über die die Halbleiterkörper 41, 42, 43 beispielsweise n-seitig kontaktiert werden können.

Vorliegend handelt es sich bei den Halbleiterkörpern 41, 42, 43 um voneinander unterschiedliche Halbleiterkörper, die im Betrieb jeweils zur Erzeugung von elektromagnetischer Strahlung einer anderen Farbe vorgesehen sind. Beispielsweise erzeugt der Halbleiterkörper 41 im Betrieb rotes Licht, der Halbleiterkörper 42 erzeugt im Betrieb grünes Licht und der Halbleiterkörper 43 erzeugt im Betrieb blaues Licht.

In der Figur 1C ist schematisch dargestellt, dass die Leuchtdioden 4 in einfacher Weise vom Träger 3 separiert werden können. Bei den Leuchtdioden 4 handelt es sich dann um separate Bauteile, die getrennt voneinander auf den CMOS-Chips 10 des Chip-Verbunds 1 angeordnet werden können. Die Leuchtdioden 4 werden dabei derart auf den CMOS-Chips 10 angeordnet, dass sich die Oberseiten 44a und 10a von Träger 44 und Chip 10 einander gegenüberliegen. Jeder Halbleiterkörper 41, 42, 43 einer jeden Leuchtdiode 4 wird dabei mechanisch an einer zugehörigen Anschlussstelle 2 des CMOS-Chips 10 befestigt und elektrisch mit dieser kontaktiert, vergleiche Figur 1E.

In einem letzten Verfahrensschritt kann der Verbund aus Leuchtdioden 4 und CMOS-Chips 10 vereinzelt werden. Die kleinste mögliche Einheit umfasst dann genau einen CMOS-Chip 10 und eine zugeordnet Leuchtdiode 4. Die Seitenflächen 10c der CMOS-Chips 10 sind also durch Vereinzeln erzeugt und weisen Spuren eines Vereinzelungsprozesses, beispielsweise Sägerillen auf.

Es ist jedoch auch möglich, dass die Leuchtmittel 100 jeweils eine Vielzahl von CMOS-Chips 10 und eine Vielzahl von Leuchtdioden 4 umfassen. In diesem Fall eignet sich das Leuchtmittel 100 besonders gut als Vollfarbendisplay, bei dem jede Leuchtdiode 4 ein Pixel repräsentiert, welches drei Unterpixel umfasst, die jeweils durch die Halbleiterkörper 41, 42, 43 gebildet sind.

Leuchtmittel 100 mit genau einer Leuchtdiode 4 und genau einem CMOS-Chip 10, wie sie beispielsweise in der Figur 1F dargestellt sind, können zum Beispiel als Lichtquellen in optischen Projektionsapparaten Verwendung finden.

Über den CMOS-Chip 10 können die Halbleiterkörper 41, 42, 43 in vorgebbarer Weise angesteuert werden.

In Verbindung mit den Figuren 2A bis 2C ist ein alternatives Ausführungsbeispiel eines hier beschriebenen Verfahrens näher erläutert. In diesem Ausführungsbeispiel sind die Halbleiterkörper 41, 42, 43 gleichartig ausgebildet. Das heißt, die Halbleiterkörper 41, 42, 43 einer jeden Leuchtdiode 4 erzeugen im Betrieb elektromagnetische Strahlung aus demselben Spektralbereich.

Beispielsweise erzeugen die Halbleiterkörper 41, 42, 43 im Betrieb UV-Strahlung. In der schematischen Schnittdarstellung der Figur 2A ist gezeigt, dass die Leuchtdioden 4 bereits auf dem Chip-Verbund 1 aufgebracht sind und jeder Halbleiterkörper 41, 42, 43 mit der zugeordneten Anschlussstelle 2 des zugeordneten CMOS-Chips 10a verbunden ist. Auf die Leuchtdioden 4 werden nun jeweils Konversionselemente 51, 52, 53 aufgebracht, die derart an der Unterseite 44b eines jeden Trägers befestigt werden, dass sie dem zugeordneten Halbleiterkörper 41, 42, 43 in dessen Abstrahlrichtung nachgeordnet sind.

Beispielsweise sind die Konversionselemente 51, 52, 53 vor dem Aufbringen auf die Leuchtdioden auf einem gemeinsamen Träger 5 aufgebracht. Die Konversionselemente können beispielsweise mit einem Halbleitermaterial, zum Beispiel einem II/VI-Halbleitermaterial gebildet sein. Sie können auf dem Träger 5 epitaktisch abgeschieden sein. Es ist jedoch auch möglich, dass es sich um keramische Konversionselemente handelt, die im Verbund, das heißt auf einem gemeinsamen Träger 5, oder einzeln auf die Leuchtdioden 4 aufgebracht werden.

Nach dem Ablösen vom Träger 5 ist ein Leuchtmittel geschaffen, bei dem jedem Halbleiterkörper 41, 42, 43 einer jeden Leuchtdiode 4 ein Konversionselement 51, 52, 53 nachgeordnet ist. Von den Halbleiterkörpern im Betrieb erzeugte elektromagnetische Strahlung tritt beispielsweise durch den strahlungsdurchlässigen Träger 44 und wird dort möglichst vollständig zu sichtbarem Licht wellenlängenkonvertiert. Jede Leuchtdiode ist dadurch beispielsweise zur Abstrahlung von rotem, grünem und blauem Licht geeignet.

Wie in der Figur 2C dargestellt ist, kann der Chip-Verbund 1 je nach Bedarf in Leuchtmittel 100 durchtrennt werden, wobei beim Separieren wieder ausschließlich durch den Chip-Verbund 1 und nicht die Leuchtdioden 4 separiert wird.

Diese Patentanmeldung beansprucht die Priorität der deutschen Patentanmeldung 102009033915.9.

## Patentansprüche

1. Verfahren zur Herstellung eines Leuchtmittels mit den folgenden Schritten:
- Bereitstellen einer Vielzahl von Leuchtdioden (4), wobei jede Leuchtdiode einen strahlungsdurchlässigen Träger (44) und zumindest zwei räumlich voneinander getrennte Halbleiterkörper (41,42,43) aufweist, jeder Halbleiterkörper (41,42,43) zur Erzeugung von elektromagnetischer Strahlung vorgesehen ist, die Halbleiterkörper (41,42,43) getrennt voneinander ansteuerbar sind und die Halbleiterkörper (41,42,43) an der Oberseite (44a) des strahlungsdurchlässigen Trägers (44) auf dem strahlungsdurchlässigen Träger (44) angeordnet sind,
- Bereitstellen eines Chip-Verbundes (1) aus CMOS-Chips (10), wobei jeder CMOS-Chip (10) an seiner Oberseite (10a) zumindest zwei Anschlussstellen (2) aufweist,
- Verbinden zumindest einer der Leuchtdioden (4) mit einem der CMOS-Chips (10), wobei die Leuchtdiode (4) an der Oberseite (44a) des strahlungsdurchlässigen Trägers (44) an der Oberseite (10a) des CMOS-Chips (10) angeordnet wird und jeder Halbleiterkörper (41,42,43) der Leuchtdiode mit einer Anschlussstelle (2) des CMOS-Chips (10) verbunden wird,
dadurch charakterisiert dass
- die zumindest eine Leuchtdiode (4) an ihrer den Halbleiterkörpern (41,42,43) abgewandten Seite des strahlungsdurchlässigen Trägers (44) eine Anschlussstelle (45) aufweist, die zur gemeinsamen elektrischen Kontaktierung aller Halbleiterkörper (41,42,43) der Leuchtdiode (4) vorgesehen ist.

2. Verfahren nach dem vorherigen Anspruch,
wobei die Anschlussstelle (2) mit einer dem strahlungsdurchlässigen Träger (44) abgewandten Oberfläche des Halbleiterkörpers (41,42,43) in direkten Kontakt gebracht wird.

3. Verfahren nach Anspruch 1,
wobei eine Vielzahl von Konversionselementen (51,52,53), die in einem Verbund vorliegen, gleichzeitig mit einer Vielzahl von Leuchtdioden (4) verbunden wird.

4. Verfahren nach einem der vorherigen Ansprüche,
wobei der Verbund aus Chip-Verbund (1) und einer Vielzahl der Leuchtdioden (4) zu einzelnen Leuchtmitteln vereinzelt wird, von denen jedes Leuchtmittel zumindest eine Leuchtdiode (4) umfasst, wobei beim Vereinzeln lediglich der Chip-Verbund (1) durchtrennt wird.

5. Leuchtmittel mit
- einem CMOS-Chip (10), wobei der CMOS-Chip (10) an seiner Oberseite zumindest zwei Anschlussstellen (2) aufweist,
- einer Leuchtdiode (4), wobei die Leuchtdiode (4) einen strahlungsdurchlässigen Träger (44) und zumindest zwei räumlich voneinander getrennte Halbleiterkörper (41,42,43) aufweist, jeder Halbleiterkörper (41,42,43) zur Erzeugung von elektromagnetischer Strahlung vorgesehen ist, die Halbleiterkörper (41,42,43) getrennt voneinander ansteuerbar sind und die Halbleiterkörper (41,42,43) an der Oberseite (44a) des strahlungsdurchlässigen Trägers auf dem strahlungsdurchlässigen Träger (44) angeordnet sind, wobei
- die Leuchtdiode (4) und der CMOS-Chip (10) sich an ihren Oberseiten (44a,10a) zugewandt sind und jeder Halbleiterkörper (41,42,43) der zumindest einen Leuchtdiode (4) mit einer Anschlussstelle (2) des CMOS-Chips (10) verbunden ist,
dadurch charakterisiert dass
- die zumindest eine Leuchtdiode (4) an ihrer den Halbleiterkörpern (41,42,43) abgewandten Seite des strahlungsdurchlässigen Trägers (44) eine Anschlussstelle (45) aufweist, die zur gemeinsamen elektrischen Kontaktierung aller Halbleiterkörper (41,42,43) der Leuchtdiode (4) vorgesehen ist.

6. Verfahren oder Leuchtmittel nach einem der vorherigen Ansprüche,
bei dem alle Halbleiterkörper (41,42,43) der zumindest einen Leuchtdiode (4) elektromagnetische Strahlung im selben Spektralbereich erzeugen und zumindest einem der Halbleiterkörper (41,42,43) ein Konversionselement (51,52,53) nachgeordnet ist, wobei das Konversionselement (51,52,53) an der dem Halbleiterkörper (41,42,43) abgewandten Unterseite (44b) des strahlungsdurchlässigen Trägers (44) angeordnet ist derart, dass im Betrieb des Halbleiterkörpers (41,42,43) von diesem emittierte elektromagnetische Strahlung durch das Konversionselement (51,52,53) tritt und von diesem zumindest zum Teil wellenlängenkonvertiert wird.

7. Verfahren oder Leuchtmittel nach einem der vorherigen Ansprüche,
bei dem zumindest zwei Halbleiterkörper (41,42,43) der zumindest einen Leuchtdiode (4) im Betrieb elektromagnetische Strahlung aus voneinander unterschiedlichen Spektralbereichen erzeugen.

8. Verfahren oder Leuchtmittel nach einem der vorherigen Ansprüche,
bei dem der strahlungsdurchlässige Träger (44) der zumindest einen Leuchtdiode eine Kunststofffolie umfasst in die und/oder auf die elektrische Leitungen zur Kontaktierung der Halbleiterkörper (41,42,43) angeordnet sind.

## Claims

1. Method for producing a luminous means comprising the following steps:
- providing a plurality of light emitting diodes (4), wherein each light emitting diode has a radiation-transmissive carrier (44) and at least two semiconductor bodies (41, 42, 43) spatially separated, each semiconductor body (41, 42, 43) is provided for generating electromagnetic radiation, the semiconductor bodies (41, 42, 43) are drivable separately from one another and the semiconductor bodies (41, 42, 43) are arranged at the top side (44a) of the radiation-transmissive carrier (44) on the radiation-transmissive carrier (44),
- providing a chip assemblage (1) composed of CMOS chips (10), wherein each CMOS chip (10) has at least two connection locations (2) at its top side (10a),
- connecting at least one of the light emitting diodes (4) to one of the CMOS chips (10), wherein the light emitting diode (4) is arranged, at the top side (44a) of the radiation-transmissive carrier (44), on the top side (10a) of the CMOS chip (10) and each semiconductor body (41, 42, 43) of the light emitting diode is connected to a connection location (2) of the CMOS chip (10),
**characterized in that**
- the at least one light-emitting diode (4) has a connection location (45), which is provided for the common electrical contacting of all semiconductor bodies (41, 42, 43) of the light-emitting diode (4), on its side of the radiation-transmissive carrier (44) facing away from the semiconductor bodies (41, 42, 43).

2. Method according to the previous claim,
the connection location (2) is brought into direct contact with a surface of the semiconductor body (41, 42, 43) facing away from the radiation-transmissive carrier (44).

3. Method according to claim 1,
wherein a plurality of conversion elements (51,52,53) present in an assemblage are simultaneously connected to a plurality of light emitting diodes (4).

4. Method according to one of the previous claims,
wherein the assemblage of chip assemblage (1) and a multiplicity of the light-emitting diodes (4) is singulated to form individual luminous means, each luminous means comprises at least one light-emitting diode (4), wherein only the chip assemblage (1) is severed during singulation.

5. Luminous means with
- a CMOS chip (10), wherein the CMOS chip (10) has at least two connection locations (2) on its top side,
- a light-emitting diode (4), wherein the light-emitting diode (4) has a radiation-transmissive carrier (44) and at least two semiconductor bodies (41, 42, 43) spatially separated from one another, each semiconductor body (41, 42, 43) is provided for generating electromagnetic radiation, the semiconductor bodies (41, 42, 43) are drivable separately from one another, and the semiconductor bodies (41, 42, 43) are arranged at the top side (44a) of the radiation-transmissive carrier on the radiation-transmissive carrier (44), the semiconductor bodies (41, 42, 43) being arranged on the top side (44a) of the radiation-transmissive carrier on the radiation-transmissive carrier (44), wherein
- the light-emitting diode (4) and the CMOS chip (10) face one another at their top sides (44a, 10a), and each semiconductor body (41, 42, 43) of the at least one light-emitting diode (4) is connected to a connection location (2) of the CMOS chip (10),
**characterized in that**
- the at least one light-emitting diode (4) has a connection point (45), which is provided for the common electrical contacting of all semiconductor bodies (41, 42, 43) of the light-emitting diode (4), on its side of the radiation-transmissive carrier (44) facing away from the semiconductor bodies (41, 42, 43).

6. Method or luminous means according to one of the previous claims,
in which all the semiconductor bodies (41, 42, 43) of the at least one light-emitting diode (4) generate electromagnetic radiation in the same spectral range and a conversion element (51, 52, 53) is arranged downstream of at least one of the semiconductor bodies (41, 42, 43), wherein the conversion element (51, 52, 53) is arranged at the underside (44b) of the radiation-transmissive carrier (44) facing away from the semiconductor bodie (41, 42, 43), such that electromagnetic radiation emitted by the semiconductor body (41, 42, 43) during operation thereof passes through the conversion element (51, 52, 53) and is at least partially wavelength-converted by the latter.

7. Method or luminous means according to one of the preceding claims,
in which at least two semiconductor bodies (41, 42, 43) of the at least one light-emitting diode (4) generate electromagnetic radiation from mutually different spectral ranges during operation.

8. Method or luminous means according to one of the preceding claims,
in which the radiation-transmissive carrier (44) of the at least one light-emitting diode comprises a plastic foil in which and/or on which electrical leads for contacting the semiconductor bodies (41, 42, 43) are arranged.

## Revendications

1. Procédé de fabrication d'un moyen lumineux comprenant les étapes suivantes:
- fournir une pluralité diodes électroluminescentes (4), chaque diode électroluminescente comportant un support perméable au rayonnement (44) et au moins deux corps semi-conducteurs (41, 42, 43) séparés dans l'espace, chaque corps semi-conducteur (41, 42, 43) étant prévu pour générer un rayonnement électromagnétique, les corps semi-conducteurs (41, 42, 43) étant commandées séparément les uns des autres et les corps semi-conducteurs (41, 42, 43) étant disposés sur le côté supérieur (44a) du support perméable au rayonnement (44),
- fournir un assemblage de puces (1) de puces CMOS (10), dans lequel chaque puce CMOS (10) a au moins deux points de connexion (2) sur sa face supérieure (10a),
- connecter d'au moins l'une des diodes électroluminescentes (4) à l'une des puces CMOS (10), la diode électroluminescente (4) étant disposée sur la côté supérieur (44a) du support perméable au rayonnement (44) sur la face supérieure (10a) de la puce CMOS (10) et chaque corps semi-conducteur (41, 42, 43) de la diode électroluminescente étant connecté à un point de connexion (2) de la puce CMOS (10),
**caractérisé en ce que**
- l'au moins une diode électroluminescente (4) présente un point de connexion (45), qui est prévu pour le contact électrique commun de tous les corps semi-conducteurs (41, 42, 43) de la diode électroluminescente (4), sur son côté du support perméable au rayonnement (44) opposé aux corps semi-conducteurs (41, 42, 43).

2. Procédé selon la revendication précédente,
dans lequel le point de connexion (2) étant mis en contact direct avec une surface du corps semi-conducteur (41, 42, 43) opposée au support perméable au rayonnement (44).

3. Procédé selon la revendication 1,
dans laquelle une pluralité d'éléments de conversion (51, 52, 53) présents dans un assemblage sont simultanément connectés à une pluralité de diodes électroluminescentes (4).

4. Procédé selon l'une des revendications précédentes,
dans lequel l'assemblage de l'assemblage de puces (1) et d'une pluralité des diodes électroluminescentes (4) étant séparés pour former des moyen lumineux individuels, chaque moyen lumineux comprend au moins une diode électroluminescente (4), dans lequel seul l'assemblage de l'assemblage de puces (1) étant séparé pendant la séparation.

5. Moyens lumineux avec
- une puce CMOS (10), dans laquelle la puce CMOS (10) présente au moins deux points de connexion (2) sur sa face supérieure,
- une diode électroluminescente (4), dans laquelle la diode électroluminescente (4) présente un support perméable au rayonnement (44) et au moins deux corps semi-conducteurs (41, 42, 43) séparés dans l'espace, chaque corps semi-conducteur (41, 42, 43) étant prévu pour générer un rayonnement électromagnétique, les corps semi-conducteurs (41, 42, 43) étant commandées séparément les uns des autres, et les corps semi-conducteurs (41, 42, 43) sont disposés sur la côté supérieur (44a) du support transmettant le rayonnement sur le support perméable au rayonnement (44), les corps semi-conducteurs (41, 42, 43) étant disposés sur la côté supérieur (44a) du support transmettant le rayonnement sur le support perméable au rayonnement (44), où
- la diode électroluminescente (4) et la puce CMOS (10) se font face sur leurs côtés supérieurs (44a, 10a), et chaque corps semi-conducteur (41, 42, 43) de l'au moins une diode électroluminescente (4) étant connecté à un point de connexion (2) de la puce CMOS (10),
**caractérisé en ce que**
- l'au moins une diode électroluminescente (4) présente un point de connexion (45), qui est prévu pour le contact électrique commun de tous les corps semi-conducteurs (41, 42, 43) de la diode électroluminescente (4), sur son côté du support perméable au rayonnement (44) opposé aux corps semi-conducteurs (41, 42, 43).

6. Procédé ou moyen lumineux selon l'une des revendications précédentes,
dans lequel tous les corps semi-conducteurs (41, 42, 43) de l'au moins une diode électroluminescente (4) génèrent un rayonnement électromagnétique dans le même domaine spectral et un élément de conversion (51, 52, 53) est disposé en aval d'au moins l'un des corps semi-conducteurs (41, 42, 43), l'élément de conversion (51, 52, 53) étant disposé sur la côté inférieure (44b) du support perméable au rayonnement (44) et opposée au corps semi-conducteur (41, 42, 43) de telle sorte que, pendant le fonctionnement du corps semi-conducteur (41, 42, 43), le rayonnement électromagnétique émis par ce dernier traverse l'élément de conversion (51, 52, 53) et est converti au moins partiellement en longueur d'onde par ce dernier.

7. Procédé ou moyen lumineux selon l'une des revendications précédentes,
dans laquelle au moins deux corps semi-conducteurs (41, 42, 43) de l'au moins une diode électroluminescente (4) génèrent un rayonnement électromagnétique dans des plages spectrales qui diffèrent l'une de l'autre en fonctionnement.

8. Procédé ou moyen lumineux selon l'une des revendications précédentes,
dans laquelle le support perméable au rayonnement (44) de l'au moins une diode électroluminescente comprend une film plastique dans lequel et/ou sur lequel sont disposés des conducteurs électriques pour mettre en contact les corps semi-conducteurs (41, 42, 43).
